(19) Europäisches Patentamt
European Patent Office
Office européen des brevets

(11) Publication number : **0 553 971 A2**

(12) # EUROPEAN PATENT APPLICATION

(21) Application number : **93300259.4**

(22) Date of filing : **15.01.93**

(51) Int. Cl.$^5$ : **C08G 73/10,** C08G 77/42, C09D 179/08

(30) Priority : **17.01.92 JP 26221/92**

(43) Date of publication of application : **04.08.93 Bulletin 93/31**

(84) Designated Contracting States : **DE FR GB**

(71) Applicant : **SHIN-ETSU CHEMICAL CO., LTD.**
**6-1, Ohtemachi 2-chome**
**Chiyoda-ku Tokyo (JP)**

(72) Inventor : **Okinoshima, Hiroshige**
**No. 3-19, Isobe-1-chome**
**Annaka-shi, Gunma-ken (JP)**
Inventor : **Kato, Hideto**
**No. 179-5, Kaminamie-machi**
**Takasaki-shi, Gunma-ken (JP)**

(74) Representative : **Stoner, Gerard Patrick et al**
**Mewburn Ellis 2 Cursitor Street**
**London EC4A 1BQ (GB)**

(54) **Curable resins, solutions thereof, processes for making them, and electronic part protective coatings.**

(57) A novel curable resin of structural formula (1) is provided wherein $R^1$ and $R^2$ are independently substituted or unsubstituted monovalent $C_{1-10}$ hydrocarbon groups, $R^3$ is a divalent $C_{1-10}$ organic group, X is a tetravalent organic group containing an aromatic or aliphatic ring, Y is a divalent organic group, Z is a divalent organic group containing an aromatic ring, W is O or NH, m is an integer of 1 to 3, and n is an integer of at least 1. It can be prepared by reacting a polyimide with an isocyanatosilane. The curable resin forms with a solvent a solution having a low viscosity and shelf stability and cures at relatively low temperatures below 300°C into coatings having heat resistance, mechanical strength, electrical properties, solvent resistance and substrate adherence.

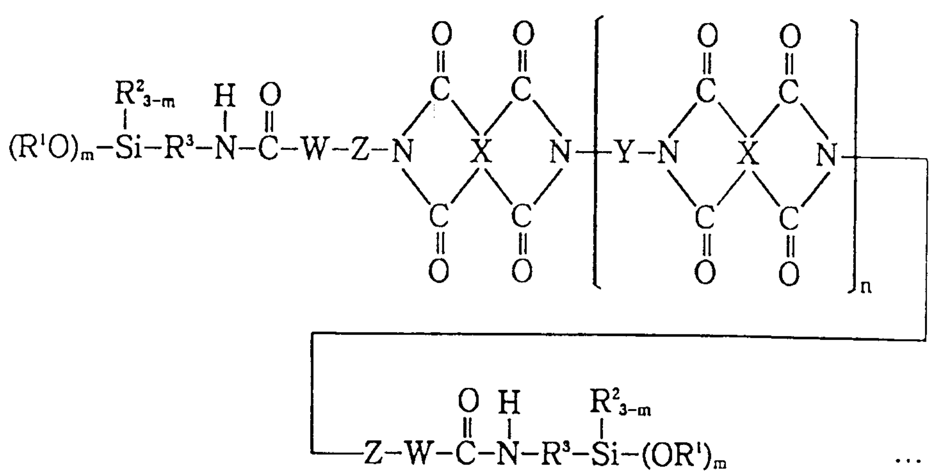

··· (1)

EP 0 553 971 A2

This invention relates to curable resins of the polyimide type, such as are used as an insulating protective coating on electric parts, to solutions of the curable resin in organic solvent, and processes for preparing the curable resins. It also relates to an electronic part protective coating obtained by curing such a resin.

Polyimide resins having heat resistance and improved electrical and mechanical properties have been utilized as insulating protective coatings for electronic parts. Since most polyimide resins are insoluble in organic solvents, polyimide protective coatings are generally prepared by using a solution of polyamic acid which is a polyimide precursor, and applying the solution to substrates, followed by heat curing. This conventional approach, however, has several problems. For example, the polyamic acid solution has a high working viscosity and requires high temperatures above 300°C for heat curing. Cured polyimide resin coatings show poor adherence to such substrates as nickel, aluminum, silicon, and silicon oxide film.

Many proposals have been made with a view to improving the adherence to substrates. JP-B-27439/1968 (which corresponds to United States Patent No. 3,325,450) and JP-B-7213/1984 (which corresponds to Great Britain Patent No. 1,571,999) propose polyimide-siloxane copolymers in which a diamine component, which is a reactant for forming polyimide, is partially replaced by a siloxane-containing diamine. Also, JP-B 32162/1983 (USP 3,950,308), 32163/1983 (USP 3,926,911), 266436/1986, 207438/1986 (USP 4,672,099), and 29510/1989 disclose methods of mixing or reacting a polyamic acid or polyimide precursor with a silane having an amino group or acid anhydride group. However, the former method had the problem that copolymers showed poor heat resistance due to an increased siloxane content. In the latter method, the polyamic acid solution experienced a substantial loss of shelf stability with an increasing amount of silane added.

It is also proposed to react polyamic acid or polyimide oligomer with an amino group-containing alkoxysilane as disclosed in Japanese Patent Application Kokai (JP-A) Nos. 157427/1981, 157428/1981, 240730/1985 (USP 4,609,700) and 266436/1986. These methods also have the problem that the amount of silane added is limited for shelf stability reasons.

For avoiding heat treatment at high temperatures above 300°C required for curing polyamic acid to form polyimide coatings, it is proposed to dissolve a polyimide resin having a siloxane linkage in a solvent as disclosed in JP-A 83228/1986, 118424/1986 (USP 4,586,997) and 118425/1986 (USP 4,701,511). Polyimide resin coatings obtained by these techniques are less solvent resistant in nature and thus unacceptable in some practical aspects.

An object of the present invention is to provide a novel curable resin of the polyimide type which can be dissolved in a solvent to form a solution preferably having a low working viscosity and good shelf stability, and which preferably can cure at relatively low temperature into cured coatings having heat resistance, mechanical strength, electrical properties, solvent resistance and substrate adherence. Further aspects of the present invention are provide such a resin solution, a process for preparing the curable resin, and a protective coating for electronic parts obtained by curing the resin.

According to a first aspect of the present invention, there is provided a curable resin of the following structural formula (1):

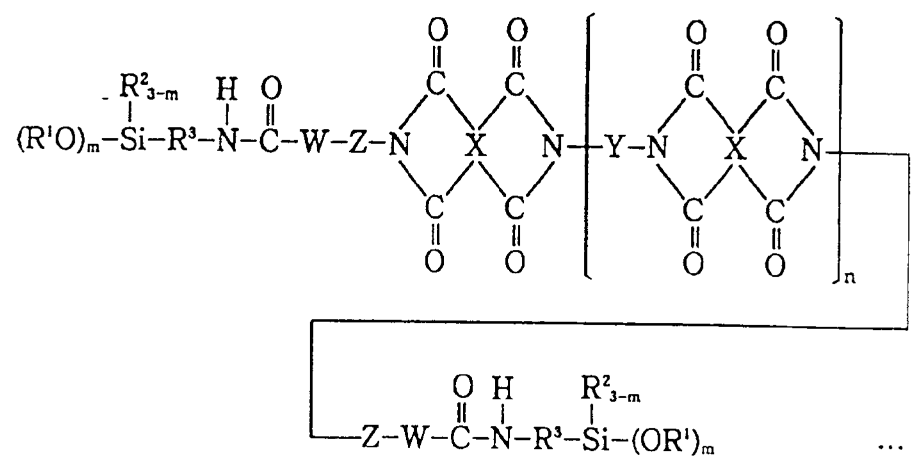

··· (1)

wherein $R^1$ and $R^2$ are independently substituted or unsubstituted monovalent hydrocarbon groups having 1 to 10 carbon atoms,

$R^3$ is a divalent organic group having 1 to 10 carbon atoms,

X is a tetravalent organic group containing an aromatic or aliphatic ring,

Y is a divalent organic group,

Z is a divalent organic group containing an aromatic ring,
W is O or NH,
m is an integer of 1 to 3, and
n is an integer of at least 1.

A second aspect of the present invention is directed to a curable resin solution which is obtained by dissolving a curable resin of formula (1) in an organic solvent.

A third aspect of the present invention is directed to a process for preparing a curable resin of formula (1). A polyimide of the following structural formula (2):

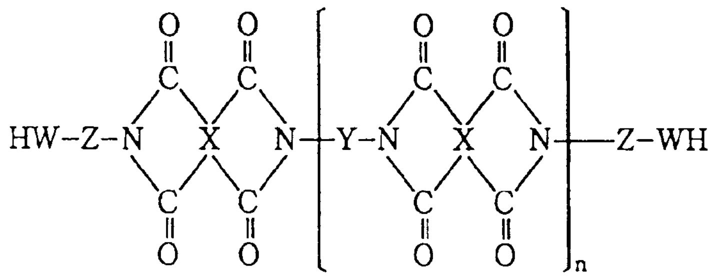

··· (2)

wherein X, Y, Z, W and n are as defined above is reacted with a silicon compound of the following structural formula (3):

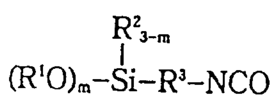

··· (3)

wherein $R^1$, $R^2$, $R^3$ and m are as defined above in an organic solvent.

According to a fourth aspect of the present invention, a cured product of a curable resin of formula (1) provides a protective coating for electronic parts.

The solution of a curable resin in an organic solvent according to the second aspect is a relatively low viscosity varnish which is easy to work with. We have found it to be stable during shelf storage. By heating at relatively low temperatures e.g. below 300°C, it readily cured into a coating having heat resistance, mechanical strength and electrical properties. Additionally, the cured coating firmly adhered to the underlying substrate and was resistant against solvents. This coating is particularly suitable for use as a protective coating on electronic parts.

## DETAILED DESCRIPTION

The curable resin of the present invention has structural formula (1).

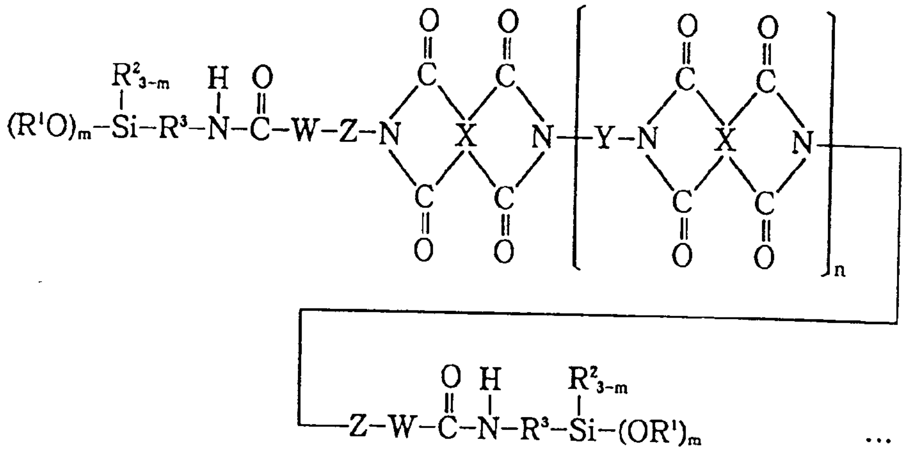

··· (1)

In formula (1), $R^1$ and $R^2$, which may be identical or different, are substituted or unsubstituted monovalent hydrocarbon groups having 1 to 10 carbon atoms, $R^3$ is a divalent organic group having 1 to 10 carbon atoms, X is a tetravalent organic group containing an aromatic or aliphatic ring, Y is a divalent organic group, Z is a divalent organic group containing an aromatic ring, and W is O or NH. Letter m is an integer of 1 to 3 and n is an integer of at least 1, preferably 1 to 100 for better workability and adhesion.

The curable resin of formula (1) can be prepared by reacting a polyimide of structural formula (2) with an isocyanatosilane of structural formula (3) in an organic solvent.

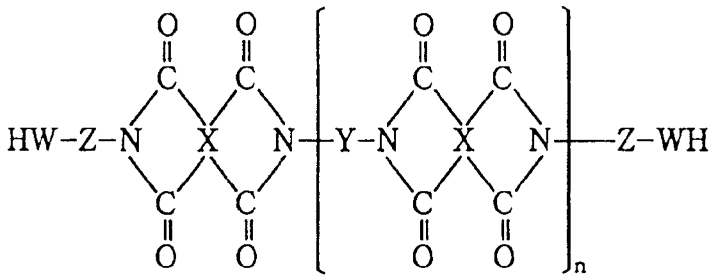

··· (2)

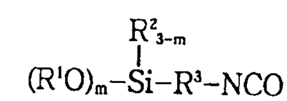

··· (3)

In formulae, $R^1$, $R^2$, $R^3$, X, Y, Z, W, m and n are as defined above.

The polyimide of formula (2) can be prepared by reacting a tetracarboxylic dianhydride of structural formula (4) with a diamine of structural formula (5) and an aromatic diamine or aminophenol of structural formula (6), all formulae defined below, in such a proportion that n molecules of the diamine of formula (5) and 2 molecules of the aromatic diamine or aminophenol of formula (6) are available per (n + 1) molecules of the tetra-carboxylic dianhydride of formula (4) wherein n is an integer of at least 1, thereby forming a polyamic acid, followed by dehydration in a conventional manner. The reaction scheme is shown below.

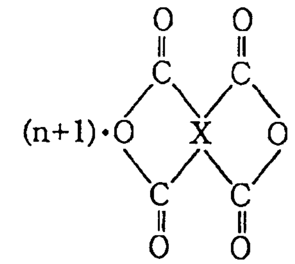

(4)

$+\ n\cdot H_2N-Y-NH_2\ +\ 2\cdot HW-Z-NH_2$

(5) (6)

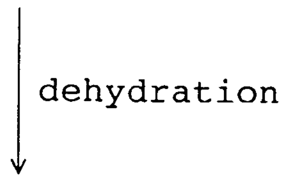


formula (2)

In the foregoing formulae, X is a tetravalent organic group having an aromatic or aliphatic ring, which originates from the tetracarboxylic dianhydride of formula (4) which is used as a starting reactant to form the polyimide of formula (2).

The acid dianhydride of formula (4) is often selected from but not limited to, pyromellitic dianhydride where X is

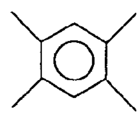

,

benzophenonetetracarboxylic dianhydride where X is

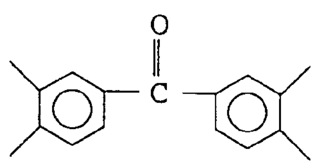

,

3,3',4,4'-biphenyltetra-carboxylic dianhydride where X is

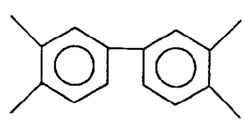

,

2,2-bis[4-(3,4-dicarboxyphenoxy)phenyl]-propane dianhydride where X is

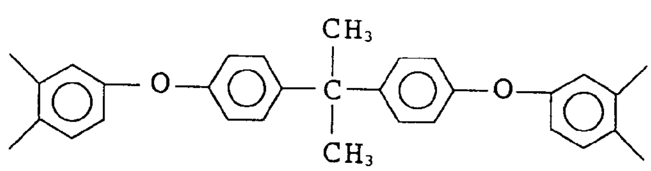

,

2,2-bis(3,4-benzenedicarboxylic anhydride)perfluoropropane where X is

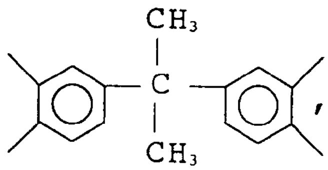
,

bis(3,4-dicarboxy-phenyl)dimethylsilane dianhydride where X is

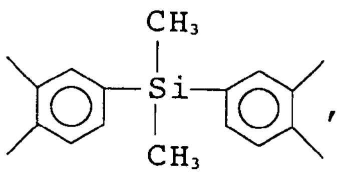
,

1,3-bis(3,4-dicarboxyphenyl)-1,1,3,3-tetramethyldisiloxane dianhydride where X is

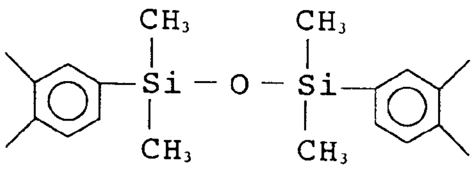
,

and 1,3-bis[4-(1,2,3,6-tetrahydrophthalic anhydride)]-1,1,3,3-tetramethyldisiloxane where X is

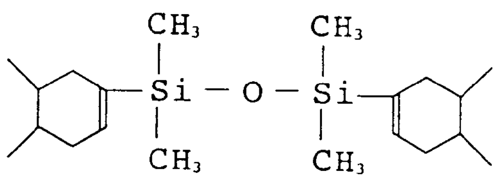
.

Suitable dianhydrides are very well known in the polyimide art.

X may be one or a mixture of the foregoing members. Therefore, when a tetracarboxylic dianhydride of formula (4) is reacted with a diamine of formula (5) and a compound of formula (6) to form a polyamide of formula (2), either a single dianhydride or a mixture of two or more dianhydrides may be used.

Y is a divalent organic group, which originates from the diamine of formula (5) which is used as a starting reactant to form the polyimide of formula (2). Illustrative, non-limiting examples of the diamine of formula (5) include aromatic ring-containing diamines, for example, p-phenylenediamine, m-phenylene-diamine, 4,4'-diaminodiphenylmethane, 4,4'-diaminodiphenyl ether, 2,2'-bis(4-aminophenyl)propane, 4,4'-diaminodiphenyl sulfone, 4,4'-diaminodiphenyl sulfide, 1,4-bis(3-aminophenoxy)benzene, 1,4-bis(4-aminophenoxy)benzene, 1,4-bis(m-aminophenylsulfonyl)benzene, 1,4-bis(p-aminophenylsulfonyl)benzene, 1,4-bis(m-aminophenylthioether)benzene, 1,4-bis(p-aminophenylthioether)benzene, 2,2-bis[4-(4-aminophenoxy)phenyl]propane, 2,2-bis[3-methyl-4-(4-aminophenoxy)phenyl]propane, 2,2-bis[3-chloro-4-(4-aminophenoxy)phenyl]propane, 1,1-bis[4-(4-aminophenoxy)phenyl]ethane, 1,1-bis[3-methyl-4-(4-aminophenoxy)-phenyl]ethane, 1,1-bis[3-chloro-4-(4-aminophenoxy)phenyl]ethane, 1,1-bis[3,5-dimethyl-4-(4-aminophenoxy)phenyl]ethane, bis[4-(4-aminophenoxy)phenyl]methane, bis[3-methyl-4-(4-aminophenoxy)phenyl]methane, bis[3-chloro-4-(4-aminophenoxy)phenyl]-methane, bis[3,5-dimethyl-4-(4-aminophenoxy)phenyl]methane, bis[4-(4-aminophenoxy)phenyl]sulfone, 2,2-bis[4-(4-aminophenoxy)phenyl]perfluoropropane, etc., and silicon diamines as shown below.

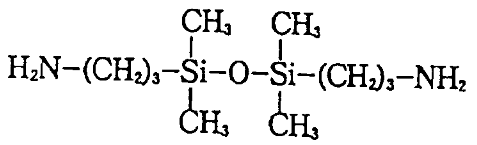 , 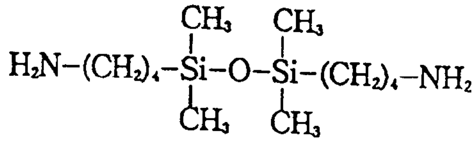 ,

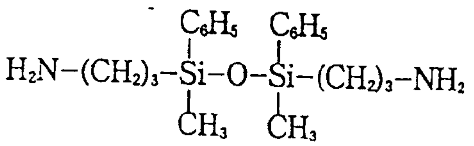 , 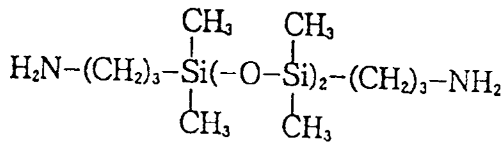 ,

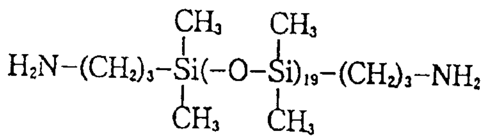 ,

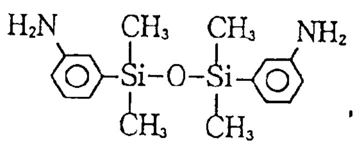 , 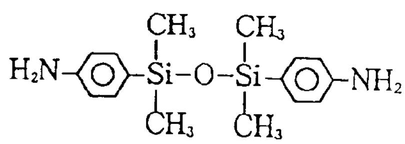 ,

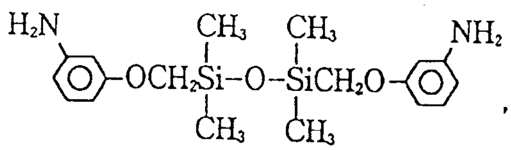 ,

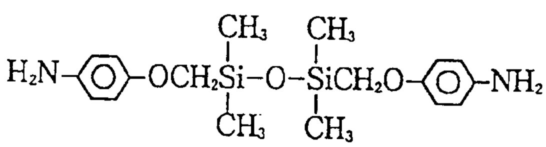 ,

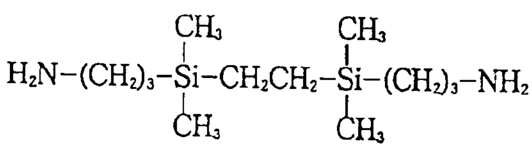 ,

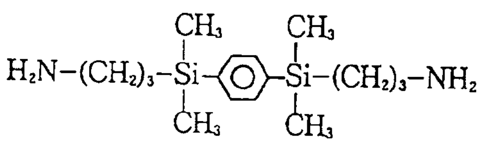

Again, suitable diamines are very well known in this art.

Y may be one or a mixture of the foregoing diamine residues. Therefore, either a single diamine or a mixture of two or more diamines may be used in producing the polyimide of formula (2).

Z is a divalent organic group, which originates from the aromatic diamine or aminophenol of formula (6)

which is used as a starting reactant to form the polyimide of formula (2). Examples of the aromatic diamine are the same as those of the aforementioned exemplary diamines of formula (5) that have an aromatic ring,though not limited thereto. That is, Z may be selected from the same range as Y.
Examples of the aminophenol include p-aminophenol and m-aminophenol though not limited thereto.

The silicon compound to be reacted with the polyimide of formula (2) is of the following structural formula (3).

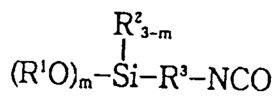

··· (3)

In formula (3), $R^1$ and $R^2$, which may be the same or different, are substituted or unsubstituted monovalent hydrocarbon groups having 1 to 10 carbon atoms, preferably 1 to 6 carbon atoms, for example, alkyl groups such as methyl, ethyl, propyl and butyl groups; alkenyl groups such as vinyl, allyl and butenyl groups; aryl groups such as phenyl and tolyl groups; and substituted ones of these groups wherein some or all of the hydrogen atoms attached to carbon atoms are replaced by halogen atoms, cyano groups, alkoxy groups or the like, for example, chloromethyl, chloropropyl, 3,3,3-trifluoropropyl, 2-cyanoethyl, methoxyethyl, and ethoxyethyl groups. Among these, alkyl groups and alkoxy-substituted alkyl groups are preferred for $R^1$ and substituted or unsubstituted alkyl and aryl groups are preferred for $R^2$.

$R^3$ is a divalent organic group, more specifically a divalent substituted or unsubstituted hydrocarbon group, for example, alkylene groups such as $-(CH_2)p-$,

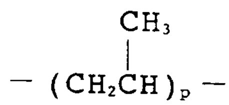 ,

arylene groups such as

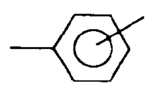 , 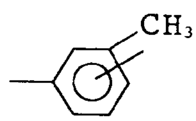 ,

substituted alkylene groups such as oxyalkylene and iminoalkylene groups as represented by $-(CH_2)_p-O-(CH_2)_q-$,

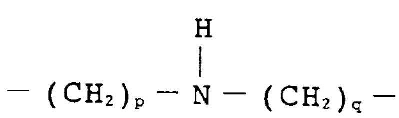 ,

substituted alkylenearylene groups such as oxyalkylenearylene and iminoalkylenearylene groups as represented by

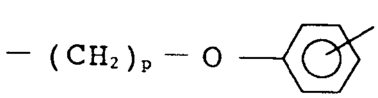 ,

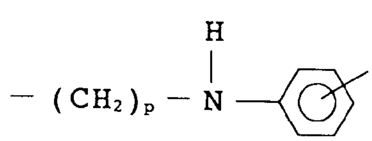

wherein p and q are integers of 1 to 3.

Illustrative, non-limiting examples of the silicon compound of formula (3) are given below.

$(CH_3O)_3Si\text{-}(CH_2)_3\text{-}NCO$,

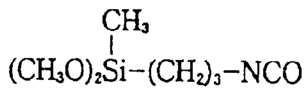 ,

$(C_2H_5O)_3Si\text{-}(CH_2)_3\text{-}NCO$,

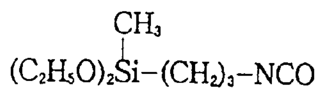 ,

$(CH_3OC_2H_4O)_3Si\text{-}(CH_2)_3\text{-}NCO$, $(CH_3O)_3Si\text{-}(CH_2)_4\text{-}NCO$,

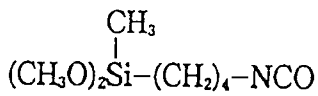 ,

$(C_2H_5O)_3Si\text{-}(CH_2)_4\text{-}NCO$,

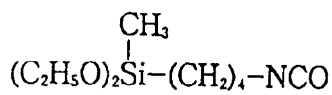 ,

$(CH_3OC_2H_4O)_3Si\text{-}(CH_2)_4\text{-}NCO$,

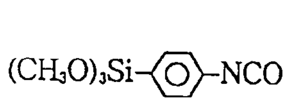 , 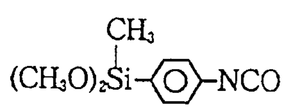 ,

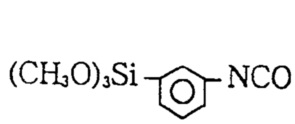 , 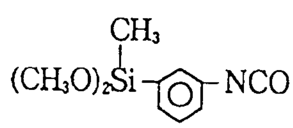 ,

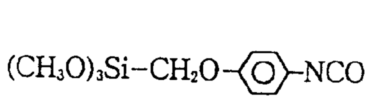 , 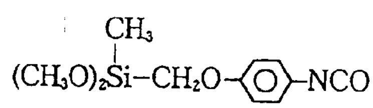 ,

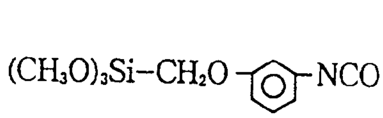 , 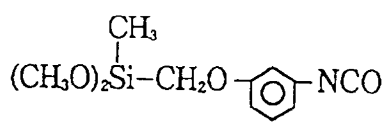

In the practice of the invention, the silicon compounds may be used alone or in combination of two or more.

The reaction between a polyimide of formula (2) and a silicon compound of formula (3) to form a curable resin of formula (1) is generally carried out in an organic solvent.

Examples of the solvent include N-methyl-2-pyrrolidone, dimethylacetamide, dimethylformamide, hexamethylphosphoramide, tetrahydrofuran, 1,4-dioxane, methyl cellosolve, butyl cellosolve, diglyme (diethylene glycol dimethyl ether), triethylene glycol dimethyl ether, diethylene glycol diethyl ether, acetone, methyl ethyl ketone, methyl isobutyl ketone, cyclopentanone, cyclohexanone, toluene, and xylene. A single solvent or a mixture of two or more may be used.

On reaction, the silicon compound of formula (3) and the polyimide of formula (2) are preferably used in a molar ratio (3)/(2) of from about 1.9 to about 2.1. The reaction temperature is preferably -20°C to 100°C, often 0°C to 80°C. The reaction time is about 1/2 to 10 hours. The reaction takes place either in the presence or absence of a catalyst. The catalyst when used may be selected from tertiary amines, for example, triethylamine, ethylenediamine and benzyldimethylamine.

The curable resin of formula (1) according to the present invention is used in the form of a solution in a suitable solvent when it is desired to apply the resin as protective films on electronic parts. The solvent may be selected from the aforementioned ones, alone or in admixture of two or more. Preferably the solvent is included such that the concentration of the resin is about 1 to 60% by weight, especially 2 to 40% by weight. The resin remains fully stable in the solution during shelf storage and the solution has a sufficiently low viscosity to be conveniently workable.

Cured films are generally obtained from the solution of curable resin of formula (1) by heating at a temperature of 100 to 300°C, preferably 150 to 300°C for about 1 to about 10 hours, whereby the alkoxysilyl group undergoes crosslinking reaction with water in the solution or atmosphere. As a result, the resin cures into a high molecular weight polymer having an imide group. We noted good heat resistance, mechanical properties, electrical properties, adherence to substrates, and solvent resistance of the cured polymer.

The curable resin of the invention should find a wide variety of applications as coatings or films on various substrates, typically semiconductor devices, for example, passivation films and protective films on semiconductor element surface, protective films over diode and transistor junctions, $\alpha$-radiation shielding films on VLSI, interlayer insulating films, ion implantation masks, conformal coatings on printed circuit boards, orienting films of liquid crystal display elements, glass fiber protective films, and solar battery surface protective films. In addition, the curable resin solution may be blended with inorganic fillers to form printing paste compositions or with conductive fillers to form conductive paste compositions.

In accordance with the above, we have been able to prepare curable resins which dissolve in an organic solvent to form a less viscous and fully shelf stable solution and which can be cured onto substrates at relatively low temperatures below 300°C to form coatings having excellent heat resistance, mechanical strength, electrical properties, solvent resistance, and adherence. The curable resin is useful in forming protective films on electronic parts, typically semiconductor devices. The processes described herein enable simple and consistent manufacture of such a curable resin.

## EXAMPLE

Examples of the present invention are given below by way of illustration and not by way of limitation.

### Example 1

A flask equipped with a stirrer, thermometer, and nitrogen purge tube was charged with 17.8 grams (0.04 mol) of 2,2-bis(3,4-benzenedicarboxylic anhydride)perfluoropropane and 200 grams of N-methyl-2-pyrrolidone as a solvent. To the flask, 80 grams of a solution containing 10.0 grams (0.05 mol) of diaminodiphenyl ether in N-methyl-2-pyrrolidone was gradually added dropwise. After the completion of addition, agitation was continued for a further 10 hours at room temperature. The flask was equipped with a reflux condenser connected to a water receiver, 30 grams of xylene was added to the flask, and the reaction system was heated to 160°C and maintained at the temperature for 6 hours. This reaction yielded 1.3 grams of water.

The resulting yellow brown reaction solution was cooled down and poured into methanol for re-precipitation. On drying, there was obtained 25.7 grams of a polyimide compound of the following structural formula.

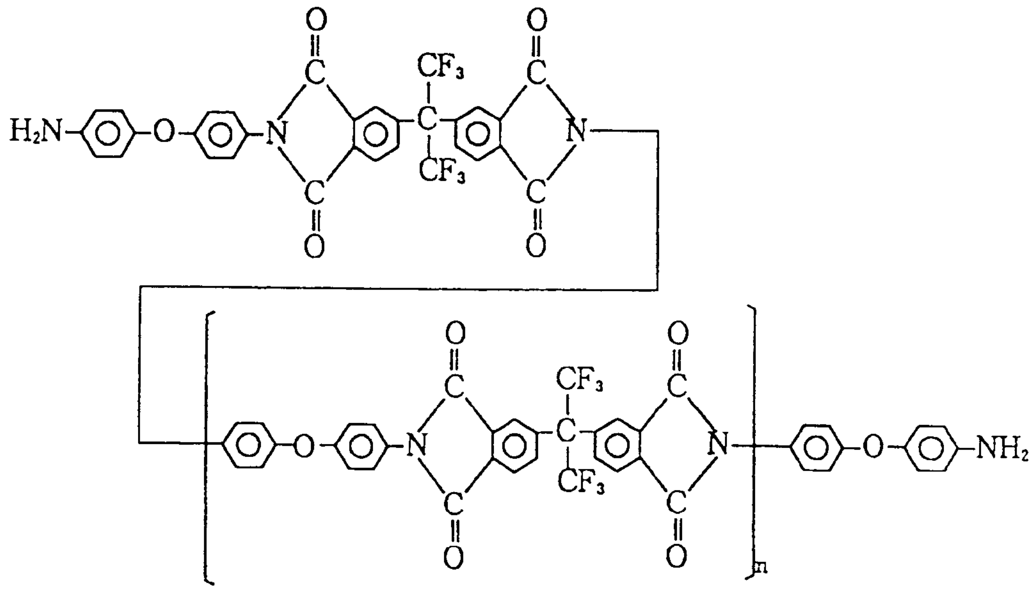

n = 4

On observation of this polyimide compound by infrared absorption spectroscopy, absorption peaks attributable to imide bond appeared at 1770 and 1720 $cm^{-1}$.

Then 23.7 grams of the polyimide compound was again dissolved in N-methyl-2-pyrrolidone, and 4.4 grams (0.018 mol) of 3-isocyanatopropyltriethoxysilane as a silicon compound was added thereto. After agitation for 10 hours at room temperature, the reaction solution was poured into methanol, obtaining 26.0 grams of a reaction product of the following structural formula.

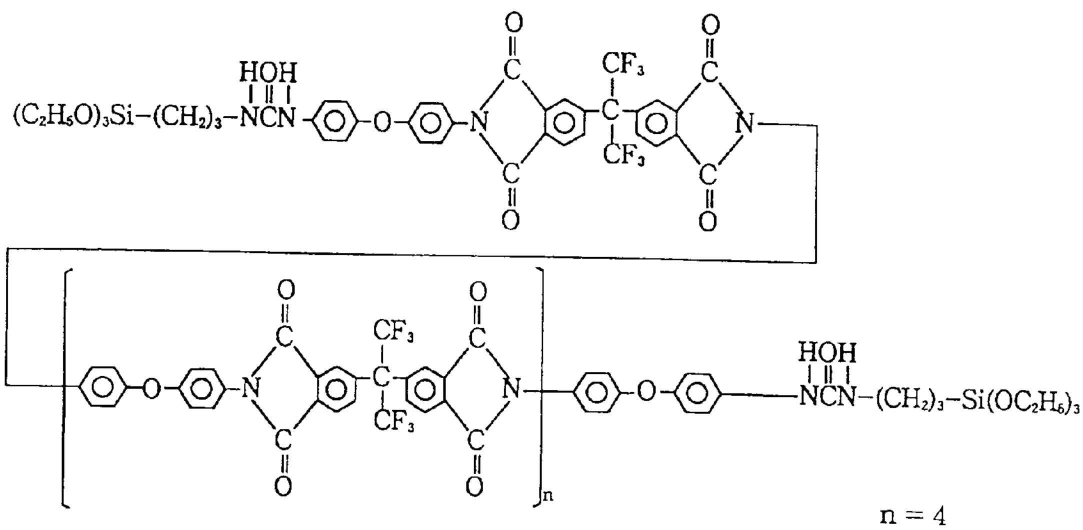

n = 4

On observation of this product by infrared absorption spectroscopy, an absorption peak at 2300 $cm^{-1}$ attributable to isocyanato did not appear, but an absorption peak at 1660 $cm^{-1}$ attributable to urea bond appeared, ascertaining the formation of an end curable resin.

Example 2

The procedure of Example 1 was repeated except that the initial charge was 20.4 grams (0.048 mol) of

1,3-bis(3,4-dicarboxyphenyl)-1,1,3,3-tetramethyldisiloxane dianhydride and 200 grams of diethylene glycol dimethyl ether as a solvent, and 60 grams of a solution containing 24.6 grams (0.060 mol) glycol dimethyl ether was added thereto. A solution of an imide compound was obtained.

To the solution, without isolating the imide compound, was added 5.2 grams (0.024 mol) of 3-isocyanatopropylmethyldiethoxysilane as a silicon compound. There was obtained 42.8 grams of an end curable resin of the following structural formula.

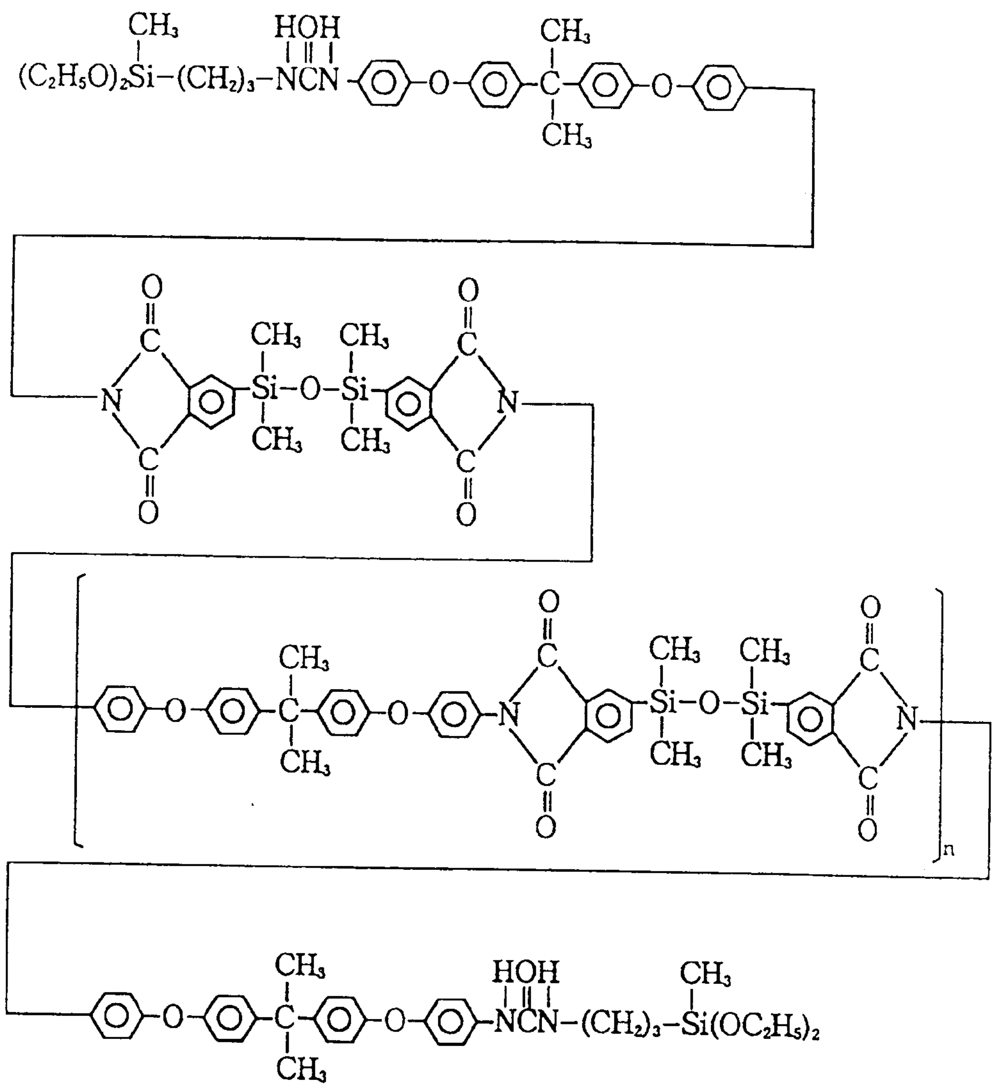

n = 4

Example 3

The procedure of Example 1 was repeated except that the initial charge was 14.71 grams (0.05 mol) of 3,3',4,4'-biphenyltetracarboxylic dianhydride and 200 grams of N-methyl-2-pyrrolidone as a solvent, 9.9 grams (0.04 mol) of 1,3-bis(3-aminopropyl)-1,1,3,3-tetramethyldisiloxane was added thereto, and 60 grams of a solution containing 8.2 grams (0.02 mol) of 2,2-bis[4-(4-aminophenoxy)phenyl]-propane in N-methyl-2-pyrrolidone was further added. To the imide compound solution was added 4.8 grams (0.02 mol) of 3-isocyanatophenyltrimethoxysilane. There was obtained 31.5 grams of an end curable resin of the following structural formula.

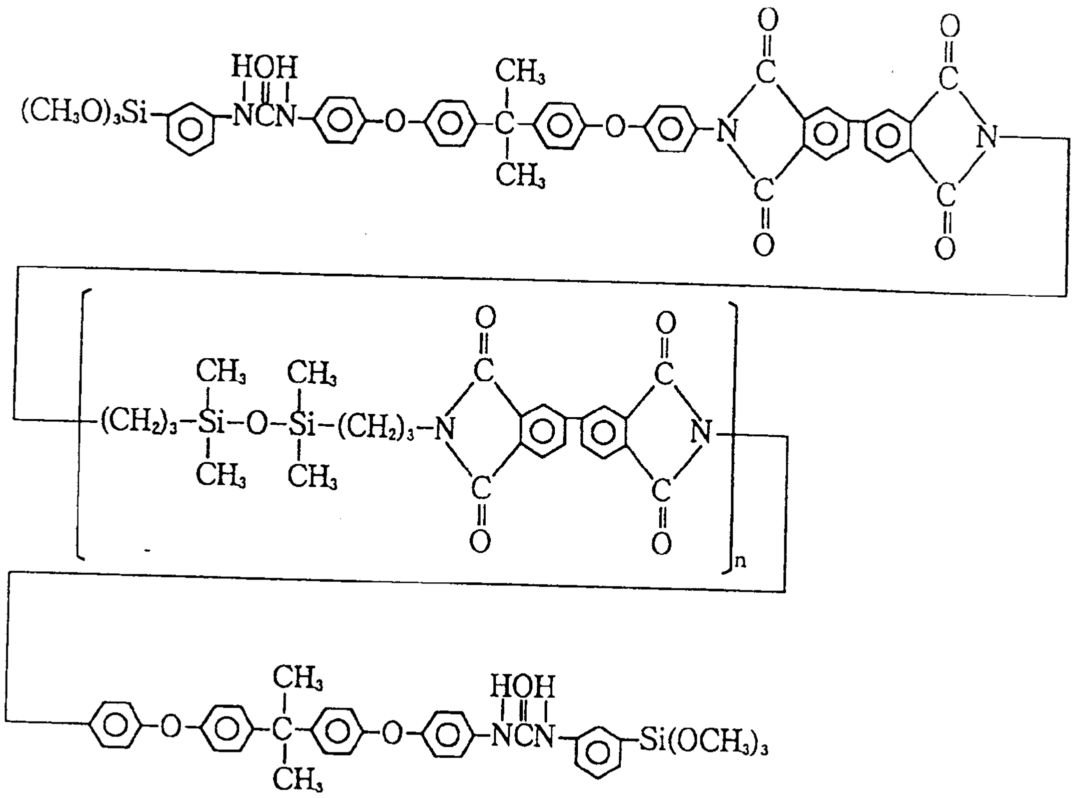

n = 4

Example 4

In accordance with the procedure of Example 1, 22.2 grams (0.05 mol) of 2,2-bis(3,4-benzenedicarboxylic anhydride)perfluoropropane, 2.2 grams (0.02 mol) of p-aminophenol and 8.0 grams (0.04 mol) of diaminodiphenyl ether were reacted in 200 grams of N-methyl-2-pyrrolidone. There was obtained 29.5 grams of a polyimide compound of the following structural formula.

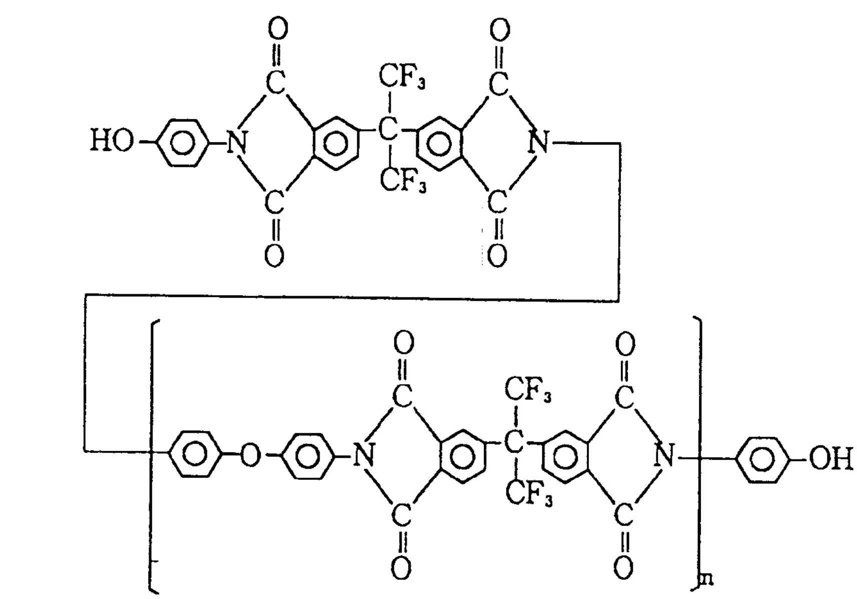

n = 4

To 160 grams of the solution containing 27.9 grams of the imide compound in N-methyl-2-pyrrolidone was added 4.4 grams (0.018 mol) of 3-isocyanatopropyltriethoxysilane. There was obtained a polyimide compound of the following structural formula.

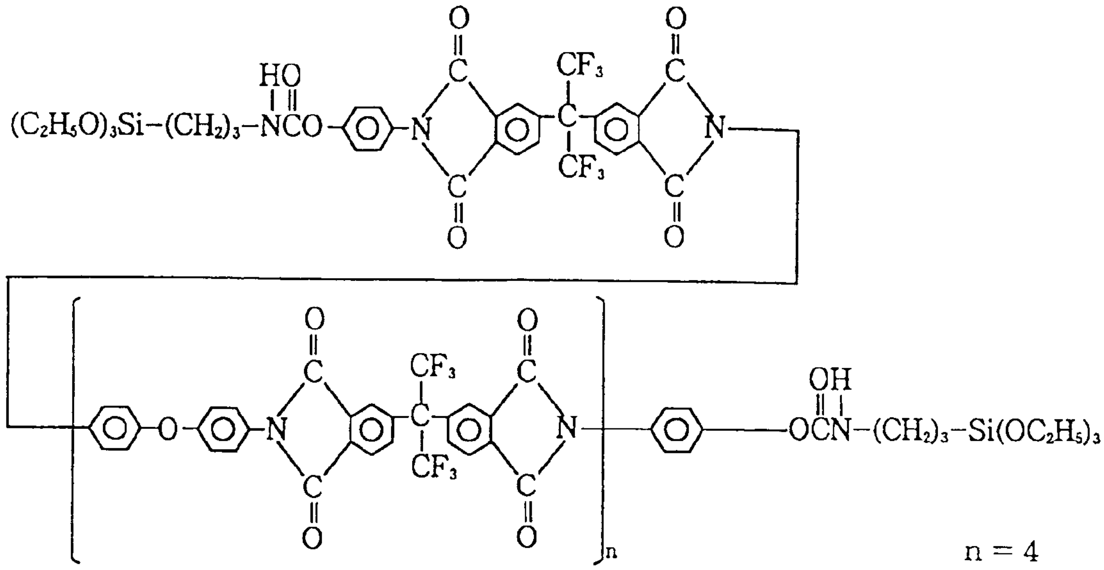

n = 4

Comparative Example 1

22.2 grams (0.05 mol) of 2,2-bis(3,4-benzenedicarboxylic anhydride)perfluoropropane and 10.0 grams (0.05 mol) of diaminodiphenyl ether were reacted in 295 grams of N-methyl-2-pyrrolidone at room temperature, obtaining a polyamic acid solution. To the solution was added 0.6 grams of 3-aminopropyltriethoxysilane. There was obtained a solution of an aminosilicon compound-containing polyamic acid.

Comparative Example 2

22.2 grams (0.05 mol) of 2,2-bis(3,4-benzenedicarboxylic anhydride)perfluoropropane and 8.0 grams (0.04 mol) of diaminodiphenyl ether were reacted in 310 grams of N-methyl-2-pyrrolidone at room temperature, obtaining a polyamic acid solution. To the solution was added 4.4 grams (0.02 mol) of 3-aminopropyltriethoxysilane. There was obtained a solution of a polyamic acid having an alkoxysilyl group at each end as shown by the following structural formula.

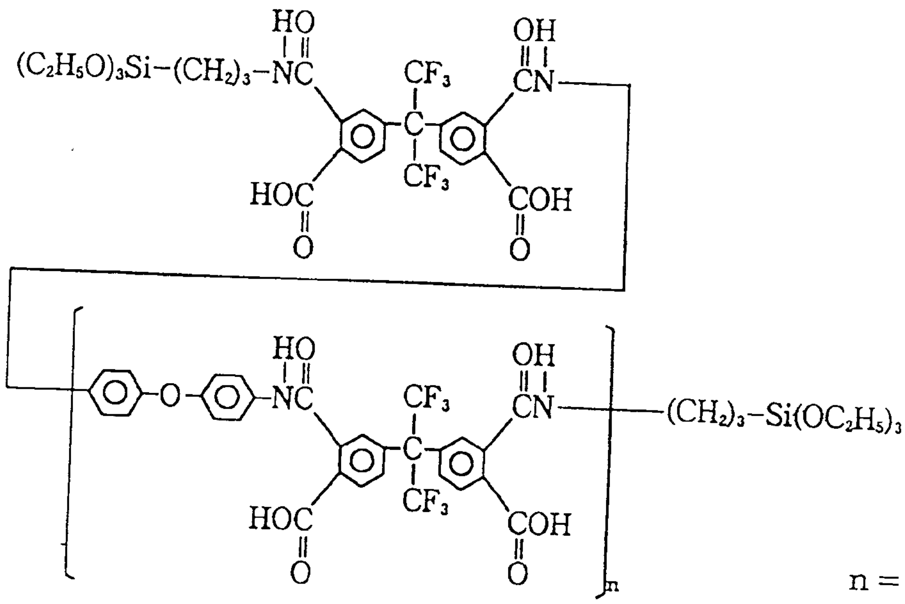

n = 4

Tests were carried out on solutions of the curable resins of Examples 1, 3 and 4 in N-methyl-2-pyrrolidone, a solution of the curable resin of Example 2 in diglyme, and the solutions of comparative Examples 1 and 2. In the shelf stability test, the solutions were measured for viscosity (centistoke at 25°C) by means of an Ostwald viscometer at the initial and after they were allowed to stand for 3 months at 25°C. In the adhesion test, the solutions were applied to silicon dioxide substrates, allowed to stand for 3 hours, and heated at 150°C for one hour and then at 300°C for a further one hour. The adhesion of the cured films to the substrates was examined by a scribed adhesion test. Solvent resistance was examined by immersing the cured films in N-methyl-2-pyrrolidone for one minute. The results are shown in Table 1.

Table 1

| Example | Solvent | Solution viscosity (cs), 3-month/initial | Cured film | |
|---|---|---|---|---|
| | | | Adhesion | Solvent resistance |
| E1 | N-methyl-2-pyrrolidone | 5/5 | 100/100 | Good |
| E2 | diglyme | 4/4 | 100/100 | Good |
| E3 | N-methyl-2-pyrrolidone | 6/6 | 100/100 | Good |
| E4 | N-methyl-2-pyrrolidone | 5/5 | 100/100 | Good |
| CE1 | N-methyl-2-pyrrolidone | gelled | 100/100 | Good |
| CE2 | N-methyl-2-pyrrolidone | gelled | 100/100 | Good |

As is evident from Table 1, the resins of Examples 1 to 4 form solutions which remain stable during shelf storage and cure at temperatures of about 300°C into films having firm bond to substrates and excellent solvent resistance.

Although some preferred embodiments have been described, many modifications and variations may be made thereto in the light of the above teachings. It is therefore to be understood that the invention may be practised otherwise than as specifically described in the Examples.

Generally stated in a broadest aspect, the invention provides a curable resin which comprises a polyimide

terminated at each end of the polyimide chain with silicon-containing terminal groups of the formula

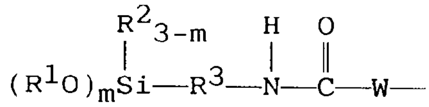

in which $R^1$, $R^2$, $R^3$ and W are as defined above.

In a broad method aspect, such a polyimide is prepared by reacting an $-NH_2$ or -OH terminated polyimide with an isocyanatosilane.

## Claims

1. A curable resin of the following structural formula (1):

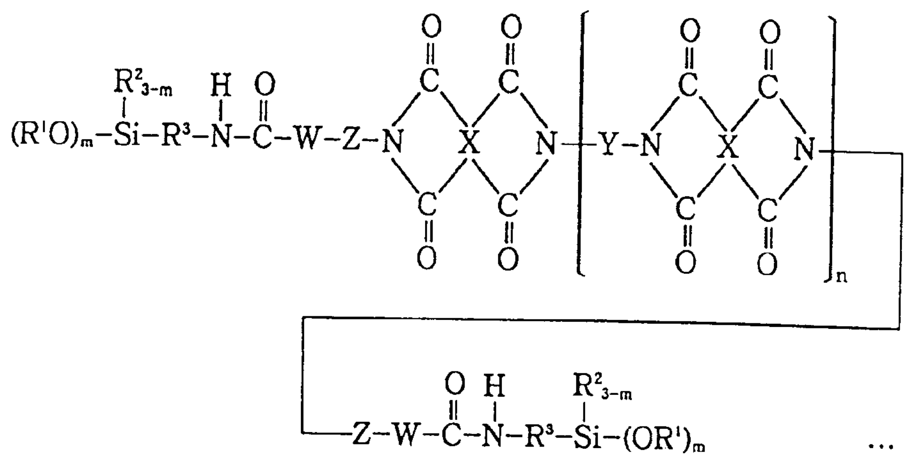

··· (1)

wherein $R^1$ and $R^2$ are independently substituted or unsubstituted monovalent hydrocarbon groups having 1 to 10 carbon atoms,

$R^3$ is a divalent organic group having 1 to 10 carbon atoms,
X is a tetravalent organic group containing an aromatic or aliphatic ring,
Y is a divalent organic group,
Z is a divalent organic group containing an aromatic ring,
W is O or NH,
m is an integer of 1 to 3, and
n is an integer of at least 1.

2. A curable resin solution comprising a curable resin as set forth in claim 1 in an organic solvent.

3. A process for preparing a curable resin of the following structural formula (1):

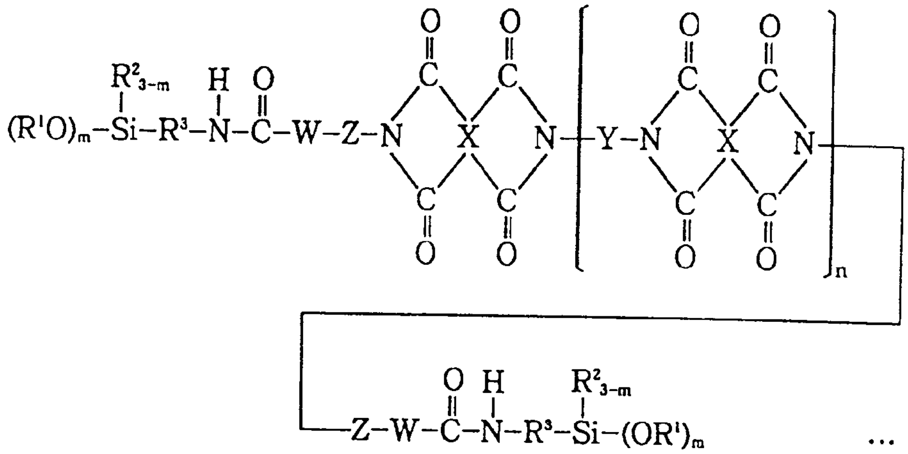

··· (1)

wherein $R^1$ and $R^2$ are independently substituted or unsubstituted monovalent hydrocarbon groups having 1 to 10 carbon atoms,

$R^3$ is a divalent organic group having 1 to 10 carbon atoms,
X is a tetravalent organic group containing an aromatic or aliphatic ring,
Y is a divalent organic group,
Z is a divalent organic group containing an aromatic ring,
W is O or NH,
m is an integer of 1 to 3, and
n is an integer of at least 1,

said process comprising the step of reacting a polyimide of the following structural formula (2):

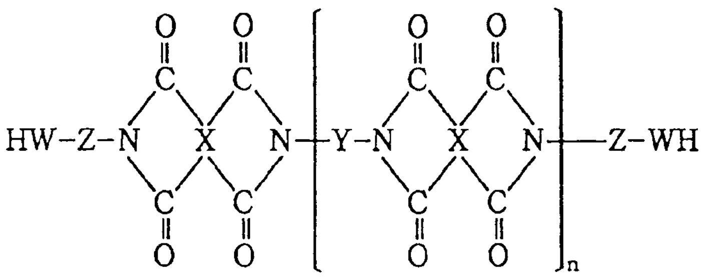

··· (2)

wherein X, Y, Z, W and n are as defined above with a silicon compound of the following structural formula (3):

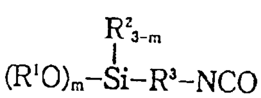

··· (3)

wherein $R^1$, $R^2$, $R^3$ and m are as defined above in an organic solvent.

**4.** A protective coating for electronic parts comprising a cured product of a curable resin as set forth in claim 1.